# EUROPÄISCHE PATENTANMELDUNG

(11) **EP 0 668 615 A1**
(43) Veröffentlichungstag der Anmeldung: **23.08.1995**
(21) Anmeldenummer: 94102492.9
(22) Anmeldetag: 18.02.1994
(51) Int. Cl.: H01L 23/495, H01L 23/66

(54) **Kunststoff-SMD-Gehäuse für einen Halbleiterchip**

(71) Anmelder: SIEMENS AKTIENGESELLSCHAFT, 80333 München (DE)
(72) Erfinder: Brenndörfer, Knut, Dipl.-Ing. (FH), D-85737 Ismaning (DE)

(57) **Zusammenfassung**

Ein Kunststoff-SMD-Gehäuse für einen Halbleiterchip (1), der darin eingekapselt ist und der mindestens ein aktives HF-Bauteil oder eine integrierte HF-Schaltung mit Anschlußstellen aufweist, die im Gehäuseinneren durch Bonddrähte (4) mit den die äußeren Anschlüsse bildenden Leiterbahnen eines Systemträgers (2, 3) kontaktiert sind, auf dem der Halbleiterchip befestigt ist, soll kostengünstig sein und auch bei sehr hohen Frequenzen über 2,4GHz gute HF-Eigenschaften besitzen. Der Systemträger (2, 3) ist als koplanare Dreiband-Streifenleitung aus mindestens einem HF-Innenleiter (3) und zu diesem in seitlichem Abstand verlaufenden, als Masseanschluß dienenden Außenleitern (2) gebildet, und die Außenleiter (2) weisen im Gehäuseinneren eine flächige Verbindung auf, auf der der Halbleiterchip (1) dem Ende des HF-Innenleiters (3) gegenüberliegend befestigt ist.

## Beschreibung

Die Erfindung betrifft ein Kunststoff-SMD-Gehäuse für einen Halbleiterchip, der darin eingekapselt ist und der mindestens ein aktives HF-Bauteil oder eine integrierte HF-Schaltung mit Anschlußstellen aufweist, die im Gehäuseinneren durch Bonddrähte mit den die äußeren Gehäuseanschlüsse bildenden Leiterbahnen eines Systemträgers kontaktiert sind, auf dem der Halbleiterchip befestigt ist.

Solche Kunststoffgehäuse für einen Halbleiterchip, der ein Einzelhalbleiterbauelement oder eine integrierte Schaltung (IC) aufweist, sind bekannt. Der Chip wird dabei auf einen metallenen Systemträger, einen sogenannten Leadframe, und zwar bei Standard-Bauelementen bzw. Standard-ICs auf dessen zentrales Teil (Insel), geklebt, gebondet und in einem Spritzgußprozeß vollständig mit Kunststoffpreßmasse so umhüllt, daß nur die als äußere Gehäuseanschlüsse dienenden Enden des Systemträgers herausragen.

Aktive Hochfrequenz-Bauteile, wie z.B. Silizium-Bipolar-Transistoren, Silizium-ICs, GaAs-MMICs (Monolithic Micro-wave Circuits), werden aus Kostengründen fast nur noch in Kunststoff-SMD-Gehäuse montiert. Je höher die Frequenz, desto stärker werden die Eigenschaften der HF-Bauteile durch das Gehäuse negativ beeinflußt. Insbesondere die neuen Mobilfunk-Bereiche bei Frequenzen von 1,8GHz und zukünftig bei 2,4GHz und höher erfordern kostengünstige Kunststoffgehäuse mit guten HF-Eigenschaften für die aktiven HF-Bauteile in Sender und Empfänger. In Senderstufen spielt auch die Wärmeleitfähigkeit des Leadframe eine Rolle, da bei manchen Anwendungen hohe Verlustleistungen abgeführt werden müssen.

Bisher wurden HF-Gehäuse so klein wie mölglich gebaut, um die Masseinduktivitäten zu minimieren. Mit höher werdenden Frequenzen und Einführung der SMD (Surface Mounted Device) -Technik stieß eine weitere Verkleinerung der Gehäuse auf Probleme, da auch relativ große Chips verpackt werden mußten. Um nun die Masse zu verbessern, wurden mehrere und den HF-Anschlüssen benachbarte Pins (Gehäuseanschlüsse) auf Masse gelegt. Diese Konfiguration verbessert zwar die Masseverhältnisse und sorgt für zusätzliche HF-Abschirmung, der Wellenwiderstand der Anordnung ist wegen den üblicherweise großen Abständen zwischen den Pins jedoch so hoch, daß eine starke Transformation stattfindet. Außerdem sind die masseführenden Anschlüsse genauso schmal wie der HF-Anschluß, so daß kein echter, niederohmiger Wellenleiter entsteht.

Der Erfindung liegt die Aufgabe zugrunde, ein kostengünstiges Kunststoff-SMD-Gehäuse zu schaffen, das auch bei sehr hohen Frequenzen über 2,4GHz noch gute HF-Eigenschaften besitzt.

Diese Aufgabe wird bei einem Kunststoff-SMD-Gehäuse der eingangs genannten Art erfindungsgemäß dadurch gelöst, daß der Systemträger als koplanare Dreiband-Streifenleitung aus mindestens einem HF-Innenleiter und zu diesem in seitlichem Abstand verlaufenden, als Masseanschluß dienenden Außenleitern gebildet ist, und daß die Außenleiter im Gehäuseinneren eine flächige Verbindung aufweisen, auf der der Halbleiterchip dem Ende des HF-Innenleiters gegenüberliegend befestigt ist.

Der HF-Innenleiter bildet dabei vorteilhaft einen niederohmigen Wellenleiter zwischen seinem äußeren Gehäuseanschlußteil und seinem dem Halbleiterchip gegenüberliegenden Ende mit einem Wellenwiderstand <100 Ohm.

Die als Masseanschluß dienenden Außenleiter des als koplanare Streifenleitung ausgebildeten Systemträgers sind vorzugsweise breiter als der bzw. die HF-Innenleiter, und der Halbleiterchip ist mindestens durch drei Bonddrähte je HF-Anschluß mit dem Systemträger kontaktiert.

Gemäß einer Weiterbildung der Erfindung weist der als koplanare Dreiband-Streifenleitung ausgebildete Systemträger zusätzliche Leiterbahnen auf, die als Gleichspannungsanschlüsse dienen. Je nach Verwendung bzw. Montageart können die aus dem Gehäuse herausragenden Enden der Leiterbahnen des Systemträgers zweckmäßig gerade oder gekröpft ausgebildet sein. Gerade Anschlüsse sind beispielsweise dann zweckmäßig, wenn die Montage des Gehäusekörpers in einem Leiterplattendurchbruch erfolgen soll.

Die mit der Erfindung erzielten Vorteile bestehen insbesondere darin, daß der Systemträger des Kunststoffgehäuses als an sich bekannte symmetrische, koplanare Dreibandleitung ausgebildet ist. Diese HF-Leitungsform besteht aus einem Streifenleiter mit endlicher Breite und Dicke sowie zwei in geringem Abstand seitlich entfernten Metallisierungsebenen mit theoretisch unendlicher Ausdehnung, welche auf Masse liegen. Die HF-Welle wird in der Koplanarleitung bei entsprechenden Abmessungen auch für niedrige Impedanzen wellenwiderstandsrichtig geführt, wobei sich die Felder in den beiden Schlitzen zwischen Innenleiter und Masseflächen ausbreiten. Bei geringen Schlitzbreiten sind niederohmige Impedanzen von <75 Ohm möglich. Der Wellenwiderstand ergibt sich durch den in den engen Schlitzen entstehenden Kapazitätsbelag.

Da sich die Felder in den Schlitzen konzentrieren, ist in der Praxis eine unendlich breite Massefläche nicht notwendig. Die Masseführung, d.h. die beiden Außenleiter sollten aber zweckmäßig eine größere Breite als der Mittelleiter, d.h. der HF-Innenleiter besitzen.

Durch die Ausbildung der Anschlüsse als Koplanarleitungen kann in einem niederohmigen HF-System (üblicherweise 50 Ohm) die Verbindung zwischen Chip und Leiterplatte wellenwiderstandsrichtig erfolgen. Dies hat den Vorteil, daß keine Transformationen im Gehäuse auftreten, und daß das Massepotential mit dem HF-führenden Innenleiter bis zum Chip, also der Stelle, wo ein optimales Massepotential notwendig ist, geführt wird.

Bei der Realisation eines Koplanar-Gehäuses sollte, ausgehend von der Leadframe-Dicke und der gewünschten Breite des Innenleiters, die Schlitzbreite so bemessen werden, daß sich im Gehäuse, also mit Kunststoff- bzw. Plastikfüllung, ein Wellenwiderstand von z.B. 50 Ohm ergibt. Dieser steigt in Luft, d.h. außerhalb des Gehäuses leicht an, was jedoch technisch kein Problem darstellt. Für problematische Anwendungen können auch die Schlitze in Luft so verkleinert werden, daß auch hier z.B. 50 Ohm Wellenwiderstand entsteht.

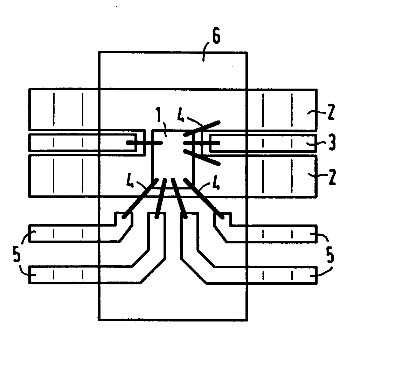

Anhand eines in der Figur der Zeichnung dargestellten Ausführungsbeispieis wird die Erfindung im folgenden weiter erläutert.

Das in der Figur dargestellte Kunststoff-SMD-Gehäuse 6 enthält einen Halbleiterchip 1, der in ein geeignetes Kunststoff- bzw. Plastikmaterial, beispielsweise einen duroplastischen Kunststoff, eingekapselt ist. Der Halbleiterchip 1, z.B. ein Si- oder GaAs-Chip, weist mindestens ein aktives Bauteil oder eine integrierte HF-Schaltung mit Anschlußstellen, sogenannten Pads, auf, die im Inneren des Gehäuses 6 durch Bonddrähte 4 mit den die äußeren Gehäuseanschlüsse bildenden Leiterbahnen eines Systemträgers 2, 3 kontaktiert sind, auf dem der Halbleiterchip 1 befestigt ist. Der aus Metall oder einer Metallegierung bestehende Systemträger 2, 3 ist als koplanare Dreiband-Streifenleitung aus mindestens einem HF-Innenleiter 3, in diesem Ausführungsbeispiel aus zwei gegenüberliegenden HF-Inenleitern 3, und zu diesen in seitlichem Abstand verlaufenden, als Masseanschluß dienenden Außenleitern 2 gebildet. Die Außenleiter 2 weisen im Inneren des Gehäuses 6 eine flächige Verbindung auf, auf der der Halbleiterchip 1 den Enden der beiden HF-Innenleiter 3 gegenüberliegend befestigt ist. Zur getrennten Gleichspannungsversorgung der aktiven HF-Bauteile des Halbleiterchips 1 ist der als koplanare Dreiband-Streifenleitung ausgebildete Systemträger 2, 3 in diesem Ausführungsbeispiel mit zusätzlichen, als Gleichspannungsanschlüsse 5 dienenden Leiterbahnen ausgerüstet.

## Patentansprüche

1. Kunststoff-SMD-Gehäuse für einen Halbleiterchip, der darin eingekapselt ist und der mindestens ein aktives HF-Bauteil oder eine integrierte HF-Schaltung mit Anschlußstellen aufweist, die im Gehäuseinneren durch Bonddrähte mit den die äußeren Gehäuseanschlüsse bildenden Leiterbahnen eines Systemträgers kontaktiert sind, auf dem der Halbleiterchip befestigt ist,
dadurch gekennzeichnet, daß
der Systemträger (2, 3) als koplanare Dreiband-Streifenleitung aus einem HF-Innenleiter (3) und zu diesem in seitlichem Abstand verlaufenden, als Masseanschluß dienenden Au- βenleitern (2) gebildet ist, und daß die Außenleiter (2) im Gehäuseinneren eine flächige Verbindung aufweisen, auf der der Halbleiterchip (1) dem Ende des HF-Innenleiters (3) gegenüberliegend befestigt ist.

2. Gehäuse nach Anspruch 1,
dadurch gekennzeichnet, daß
der HF-Innenleiter (3) einen niederohmigen Wellenleiter zwischen seinem äußeren Gehäuseanschlußteil und seinem dem Halbleiterchip (1) gegenüberliegenden Ende mit einem Wellenwiderstand <100 Ohm bildet.

3. Gehäuse nach Anspruch 1 oder 2,
dadurch gekennzeichnet, daß
die als Masseanschluß dienenden Außenleiter (2) des als koplanare Dreiband-Streifenleitung ausgebildeten Systemträgers (2, 3) breiter als der bzw. die HF-Innenleiter (3) sind.

4. Gehäuse nach einem der Ansprüche 1 bis 3, dadurch gekennzeichnet, daß
der Halbleiterchip (1) durch mindestens drei Bonddrähte (4) je HF-Anschluß mit dem Systemträger (2, 3) kontaktiert ist.

5. Gehäuse nach einem der Ansprüche 1 bis 4, dadurch gekennzeichnet, daß
der als koplanare Dreiband-Streifenleitung ausgebildete Systemträger (2, 3) zusätzliche Leiterbahnen aufweist, die als Gleichspannungsanschlüsse (5) dienen.

6. Gehäuse nach einem der Ansprüche 1 bis 5, dadurch gekennzeichnet, daß
die aus dem Gehäuse (6) herausragenden Enden der Leiterbahnen des Systemträgers (2, 3, 5) gerade oder gekröpft ausgebildet sind.
